# EUROPÄISCHE PATENTSCHRIFT

(11) **EP 0 987 797 B1**
(45) Veröffentlichungstag und Bekanntmachung des Hinweises auf die Patenterteilung: **25.06.2003**
(21) Anmeldenummer: 99114630.9
(22) Anmeldetag: 26.07.1999
(51) Int. Cl.: H01R 33/05, B60Q 3/02

(54) **Elektrische Anschlussvorrichtung**
Electrical connection device
Dispositif de raccordement électrique

(30) Priorität: 15.09.1998 DE 19842236
(43) Veröffentlichungstag der Anmeldung: 22.03.2000
(73) Patentinhaber: Delphi Technologies, Inc., Troy, MI 48007 (US)
(72) Erfinder: Gärtner, Markus, 42105 Wuppertal (DE)
(74) Vertreter: Manitz, Finsterwald & Partner

(56) Entgegenhaltungen:
- DE-A- 19 654 527
- US-A- 3 699 495
- US-A- 3 915 544
- US-A- 4 640 561
- US-A- 5 288 249
- US-A- 5 615 944

## Beschreibung

Die vorliegende Erfindung betrifft eine elektrische Anschlußvorrichtung nach dem oberbegriff des Anspruchs 1 (vgl. US-A-5,615,944) insbesondere für eine Fahrzeuginnenbeleuchtung, zum Verbinden einer flexiblen bedruckten Schaltung mit einem austauschbaren elektrischen Bauteil. Ferner betrifft die vorliegende Erfindung ein Verfahren zum Herstellen einer solchen Anschlußvorrichtung.

Es ist die Aufgabe der vorliegenden Erfindung, eine einfache und kostengünstige elektrische Anschlußvorrichtung und ein solches Verfahren zum Verbinden einer bedruckten Schaltung mit einem austauschbaren elektrischen Bauteil zur Verfügung zu stellen. Dabei soll eine gleichbleibend hohe Fertigungsqualität gewährleistet werden und die Anzahl der verwendeten Teile möglichst gering sein.

Diese Aufgabe wird durch eine elektrische Anschlußvorrichtung nach Anspruch 1 und ein Verfahren nach Anspruch 8 gelöst.

Gemäß der vorliegenden Erfindung ist es vorgesehen, daß ein leitender Bereich der bedruckten Schaltung in Klemmkontakt mit einer Aufnahme steht, die ein elektrisch isolierendes Basisteil und elektrisch leitende Halteelemente für das Bauteil aufweist. Die elektrisch leitenden Halteelemente erfüllen dabei eine Doppelfunktion. Zum einen stellen sie zusammen mit dem Basisteil einen Teil des Klemmkontakts dar und zum anderen dienen sie zum Halten des Bauteils, beispielsweise einer Glühlampe.

Hierdurch sind keine gesonderten Anschlußstecker und Anschlußgehäuse erforderlich, die beispielsweise auf die bedruckte Schaltung aufgelötet werden müßten. Erfindungsgemäß ist mindestens ein Halteelement und ein Basisteil vorgesehen. Je nach Ausgestaltung der Erfindung können aber auch mehrere Halteelemente bzw. Basisteile vorgesehen sein. Zur Montage ist lediglich ein einfaches Werkzeug bereitzustellen. Hierdurch können die Stückkosten für die erfindungsgemäße Anschlußvorrichtung erheblich verringert und eine gleichbleibend hohe Fertigungsqualität auf einfache Weise sichergestellt werden. Die Anzahl der benötigten Bauteile kann bei der erfindungsgemäßen Lösung auf ein Minimum beschränkt werden.

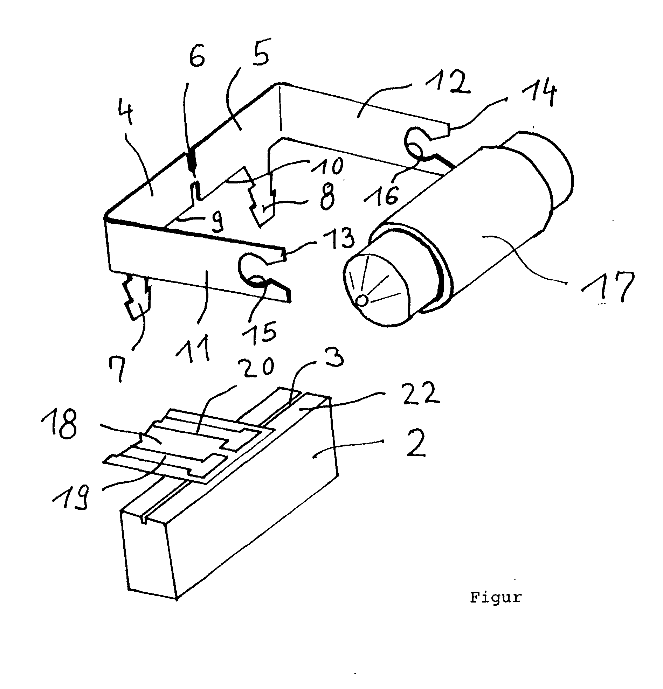

Vorteilhafte Ausführungsformen der Erfindung sind in der Beschreibung, der Figur sowie den Unteransprüchen angegeben.

Eine erste vorteilhafte Ausführungsform der vorliegenden Erfindung sieht vor, daß das Basisteil zumindest eine Vertiefung oder Nut zur Klemmung der flexiblen bedruckten Schaltung (FPC) aufweist. Durch eine derartige Vertiefung im Basisteil kann die Klemmwirkung zwischen Halteelement und bedruckter Schaltung deutlich erhöht werden, da das Halteelement in die Vertiefung eindringen kann, wobei die bedruckte Schaltung hierbei verformt und ebenfalls in die Vertiefung eingedrückt wird. Besonders vorteilhaft ist es dabei, wenn die Vertiefung in Form einer Nut ausgebildet ist, da in diesem Fall auch die Halteelemente im Bereich der Nut in das Basisteil gesteckt werden können, so daß durch die Nut gleichzeitig eine Positionierung und Ausrichtung der Halteelemente erfolgt. Die Breite der Nut wird hierbei durch die Materialstärke der Halteelemente sowie durch die in der Nut aufzunehmende flexible bedruckte Schaltung bestimmt. Die Tiefe der Nut wird hierbei so gewählt, daß ein dauerhafter Klemmkontakt gewährleistet wird.

Eine weitere vorteilhafte Ausführungsform der vorliegenden Erfindung sieht vor, daß die Halteelemente aus elektrisch leitendem Federblech hergestellt sind. Hierdurch wird zum einen die Leitungsfunktion erfüllt und zum anderen eine einfache Aufnahme für einen Verbraucher geschaffen, da dieser zwischen federnden Haltearmen der Halteelemente aufgenommen werden kann, ohne daß ein gesonderter Sockel hierfür vorgesehen werden muß. Die Doppelfunktion der Halteelemente trägt erheblich zur Einsparung zusätzlicher Bauteile bei.

Nach einer weiteren Ausbildung der Erfindung weist jedes Halteelement zumindest einen Verbindungsabschnitt für eine Verbindung mit dem Basisteil auf, der vorzugsweise keilartig und mit einer Sägezahnkontur ausgebildet ist. Ein derartiger Verbindungsabschnitt, dessen Außenkontur auch als "tannenbaumartig" bezeichnet werden kann, ermöglicht ein Eindrücken des Halteelementes in das Basisteil aus Kunststoff derart, daß eine kraft- und formschlüssige Verbindung erzielt wird. Beim Einführen der Verbindungsabschnitte in das Basisteil drückt sich die sägezahnartige Kontur so in das Basisteil ein, daß ein Widerhakeneffekt eintritt und eine unlösbare Verbindung zwischen Basisteil und Halteelement erzielt ist.

Bevorzugt ist das elektrische Bauteil, beispielsweise eine Glühlampe, zwischen zwei Schenkeln der Halteelemente geklemmt, so daß hier ein leichter Austausch des Bauteiles möglich ist.

Bei dem erfindungsgemäßen Verfahren zum Herstellen der oben beschriebenen Anschlußvorrichtung findet ein zunächst aus zwei einstückig verbundenen Halteteilen bestehendes, durch Stanzen und Biegen hergestelltes Blechteil Verwendung. Hierbei wird nach dem Eindrücken der beiden Halteteile, die zunächst über eine Brücke verbunden sind, anschließend die Brücke zwischen den Halteelementen abgetrennt, wodurch zwei voneinander elektrisch isolierte Halteteile geschaffen sind, die unlösbar in dem Basisteil verankert sind. Während dieses Vorgangs ist gleichzeitig die bedruckte Schaltung mit den Halteelementen kontaktiert.

Bevorzugt erfolgt das Eindrücken der Halteelemente in das Basisteil und das Abtrennen der Brücke zwischen den Halteelementen nacheinander in einem Arbeitsgang und in einem Werkzeug.

Nachfolgend wird die vorliegende Erfindung anhand einer beispielhaften Ausführungsform und unter Bezugnahme auf die beigefügte Zeichnung beschrieben.

Die einzige Figur zeigt eine dreidimensionale Explosionsdarstellung einer Ausführungsform der vorliegenden Erfindung.

Die in der Figur dargestellte elektrische Anschlußvorrichtung weist ein im vorliegenden Ausführungsbeispiel quaderförmiges Basisteil 2 aus nichtleitenden Kunststoff auf, an dessen Oberseite 22 eine Vertiefung in Form einer durchgehenden Nut 3 vorgesehen ist, die sich über die gesamte Länge des Basisteils 2 erstreckt. Ferner weist die elektrische Anschlußvorrichtung zwei Halteelemente 4 und 5 aus elektrisch leitendem Federblech auf, die jedoch bei der in der Figur dargestellten Vormontageposition noch durch eine Brücke 6 einstückig miteinander verbunden sind. Jedes Halteelement 4, 5 ist im wesentlichen L-förmig ausgebildet, wobei die beiden Halteelemente durch die Brücke 6 derart miteinander verbunden sind, daß sie gemeinsam eine U-förmige Anordnung bilden. Die beiden Schenkel des U bilden jeweils einen Haltearm 11 und 12, an dessen freiem Ende 13, 14 jeweils eine Aufnahmeöffnung 15, 16 für ein austauschbares elektrisches Bauteil 17 vorgesehen ist, das im vorliegenden Fall durch einen Leuchtkörper für eine Fahrzeuginnenbeleuchtung gebildet ist.

Von der Basis jedes Halteelementes 4, 5 erstreckt sich rechtwinklig jeweils ein Verbindungsabschnitt 7, 8, der keilartig und mit einer Sägezahnkontur ausgebildet ist, die Widerhaken bildet. Die in der Figur unteren Stirnseiten 9, 10 der Halteelemente 4, 5 bilden jeweils Klemmflanken für eine Klemmung einer bedruckten Schaltung, wie nachfolgend näher erläutert wird.

Wie die Figur zeigt, ist zur Kontaktierung des Bauteils 17 eine flexible bedruckte Schaltung 18 vorgesehen, auf der sich zwei Leiterbahnen 19 und 20 befinden, die parallel zueinander verlaufen und an ihren Enden verbreitert sind. Zur Montage der elektrischen Anschlußvorrichtung wird die flexible bedruckte Schaltung (FPC) 18 mit den verbreiterten Bereichen der Leiterbahnen 19 und 20 über der Nut 3 des Basisteils 2 angeordnet, woraufhin die über die Brücke 6 noch einstückig verbundenen Halteelemente 4, 5 mit ihren Verbindungsabschnitten 7, 8 in die Nut 3 gepreßt werden. Hierbei werden die verbreiterten Enden der Leiterbahnen 19 und 20 von den Klemmflanken 9, 10 der Halteelemente 4, 5 in die Nut 3 hineingedrückt, wobei ein elektrischer Kontakt zwischen den Halteelementen 4, 5 und den Leiterbahnen 19 und 20 erzeugt wird.

Um das Einpressen der Verbindungsabschnitte 7, 8 in das Basisteil 2 zu erleichtern, können im Bereich der Nut 3 Aufnahmeöffnungen (nicht gezeigt) vorgesehen werden, deren Eingangsquerschnitt etwas schmaler als die Breite der Verbindungsabschnitte 7, 8 ist. Hierdurch gibt beim Einpressen der Kunststoff des Basisteils 2 etwas nach, so daß die Flanken der Verbindungsabschnitte 7, 8 fest in dem Basisteil 2 verankert sind, wobei ein Zurückziehen durch die Widerhaken der Verbindungsabschnitte 7, 8 verhindert ist.

Im unmittelbar anschließenden Herstellungsschritt wird innerhalb des gleichen Werkzeugs die Verbindungsbrücke 6 zwischen den Halteelementen 4 und 5 getrennt, wodurch die beiden Halteelemente 4, 5 voneinander elektrisch isoliert sind. Zuletzt muß lediglich das Bauteil 17 in die Aufnahmen 15, 16 der freien Enden 13, 14 der Haltearme 11, 12 eingesetzt werden, wobei die Federwirkung der Haltearme ein Herausfallen des Bauteils verhindert und eine gute Kontaktierung gewährleistet.

Es versteht sich von selbst, daß die Erfindung nicht auf das dargestellte Ausführungsbeispiel beschränkt ist, und daß das Basisteil 2 auch Bestandteil eines Gehäuses, beispielsweise eines Lampengehäuses sein kann. Auch ist die Verwendung der erfindungsgemäßen Anschlußvorrichtung für Schmelzsicherungen oder andere elektrische Bauteile möglich.

Durch die erfindungsgemäße Anschlußvorrichtung sind keine gesonderten Bauteile wie Stecker, Steckergehäuse und dergleichen für eine zuverlässige Verbindung erforderlich, so daß mit einfachen Werkzeugen eine preisgünstige Herstellung erfolgen kann. Die Qualität der erfindungsgemäßen Verbindung ist sehr hoch und konstant, da die Genauigkeit des Zusammenbaus lediglich durch Maschinenparameter bestimmt ist.

### Bezugszeichenliste

- 2: Basisteil
- 3: Nut
- 4, 5: Halteelement
- 6: Brücke
- 7, 8: Verbindungsabschnitt
- 9, 10: Klemmflanke
- 11, 12: Haltearm
- 13, 14: freies Ende
- 15, 16: Aufnahme
- 17: elektrisches Bauteil
- 18: flexible bedruckte Schaltung (FPC)
- 19, 20: Leiterbahn
- 22: Oberseite

## Patentansprüche

1. Elektrische Anschlußvorrichtung, insbesondere für eine Fahrzeuginnenbeleuchtung, zum Verbinden eines austauschbaren elektrischen Bauteils (17), vorzugsweise eines elektrischen Verbrauchers, mit einer vorzugsweise flexiblen bedruckten Schaltung (18), wobei zumindest ein leitender Bereich der bedruckten Schaltung (18) in Klemmkontakt mit einer Aufnahme steht, die ein elektrisch isolierendes Basisteil (2) und elektrisch leitende Halteelemente (4, 5) für das Bauteil (17) aufweist, **dadurch gekennzeichnet, daß** die beiden Halteelemente (4, 5) über eine abtrennbare Brücke (6) miteinander verbunden sind.

2. Elektrische Anschlußvorrichtung nach Anspruch 1, **dadurch gekennzeichnet, daß** das Basisteil (2) zumindest eine Vertiefung (3) zur Klemmung der flexiblen bedruckten Schaltung (18) aufweist, wobei vorzugsweise die Halteelemente im Bereich der Vertiefung (3) in das Basisteil (2) gesteckt sind.

3. Elektrische Anschlußvorrichtung nach Anspruch 1, **dadurch gekennzeichnet, daß** die Halteelemente (4, 5) aus elektrisch leitendem Federblech hergestellt sind.

4. Elektrische Anschlußvorrichtung nach Anspruch 1, **dadurch gekennzeichnet, daß** jedes Halteelement (4, 5) zumindest einen Verbindungsabschnitt (7, 8) für eine Verbindung mit dem Basisteil (2) aufweist, der vorzugsweise keilartig und mit einer Sägezahnkontur ausgebildet ist.

5. Elektrische Anschlußvorrichtung nach Anspruch 1, **dadurch gekennzeichnet, daß** das Bauteil (17) zwischen zwei Schenkeln (11, 12) der Halteelemente (4, 5) geklemmt ist.

6. Elektrische Anschlußvorrichtung nach Anspruch 1, **dadurch gekennzeichnet, daß** Basisteil (2) und Halteelemente (4, 5) eine unlösbare Verbindung bilden.

7. Elektrische Anschlußvorrichtung nach Anspruch 1, **dadurch gekennzeichnet, daß** ein Ende jedes Halteelementes (4, 5) mit einer Aufnahme (15, 16) für das Bauteil (17) versehen ist.

8. Verfahren zum Herstellen einer elektrischen Anschlußvorrichtung nach zumindest einem der vorstehenden Ansprüche, umfassend die folgenden Schritte:
- Eindrücken zweier zunächst über eine Brücke verbundenen Halteelemente in ein Basisteil, wobei zwischen dem Basisteil und den Halteelementen eine vorzugsweise flexible bedruckte Schaltung angeordnet ist und dadurch ein Klemmkontakt zwischen den Halteelemente und leitenden Bereichen der flexiblen bedruckten Schaltung hergestellt wird;
- Abtrennen der Brücke zwischen den Halteelementen, um zwei voneinander elektrisch isolierte Halteelemente zu schaffen.

9. Verfahren nach Anspruch 8,
wobei das Eindrücken der Halteelemente in das Basisteil und das Abtrennen der Brücke zwischen den Halteelementen nacheinander in einem Arbeitsgang erfolgt.

10. Verfahren nach Anspruch 8 oder 9,
wobei die flexible bedruckte Schaltung von den Halteelemente in eine Vertiefung, vorzugsweise eine Nut, des Basisteiles eingedrückt wird.

## Claims

1. Electrical connector apparatus, in particular for a vehicle interior lighting, for the connection of a replaceable electrical component (17), preferably of an electrical consumer, having a preferably flexible printed circuit (18), with at least one conductive region of the printed circuit (18) being in clamping contact with a receiver which has an electrically insulating base part (2) and electrically conductive holder elements (4, 5) for the component (17), **characterised in that** the two holder elements (4, 5) are connected to one another via a separable bridge (6).

2. Electrical connector apparatus in accordance with claim 1, **characterised in that** the base part (2) has at least one recess (3) for the clamping of the flexible printed circuit (18), with the holder elements preferably being plugged into the base part (2) in the-region of the recess (3).

3. Electrical connector apparatus in accordance with claim 1, **characterised in that** the holder elements (4, 5) are manufactured of electrically conductive resilient sheet metal.

4. Electrical connector apparatus in accordance with claim 1, **characterised in that** each holder element (4, 5) has at least one connection section (7, 8) for a connection to the base part (2) which is preferably designed in the manner of a wedge and with a sawtooth contour.

5. Electrical connector apparatus in accordance with claim 1, **characterised in that** the component (17) is clamped between two limbs (11, 12) of the holder elements (4, 5).

6. Electrical connector apparatus in accordance with claim 1, **characterised in that** the base part (2) and the holder elements (4, 5) form a non-releasable connection.

7. Electrical connector apparatus in accordance with claim 1, **characterised in that** an end of each holder element (4, 5) is provided with a receiver (15, 16) for the component (17).

8. Method for the manufacture of an electrical connector apparatus in accordance with at least one of the preceding claims, comprising the following steps:
- pressing of two holder elements which are at first connected via a bridge into a base part, with a preferably flexible printed circuit being arranged between the base part and the holder elements and with a clamped contact thereby being produced between the holder elements and conductive regions of the flexible printed circuit;
- separation of the bridge between the holder elements in order to produce two holder elements which are electrically insulated from one another.

9. Method in accordance with claim 8,
with the pressing of the holder elements into the base part and the separation of the bridge between the holder elements taking place one after the other in one work step.

10. Method in accordance with claim 8 or claim 9,
with the flexible printed circuit being pressed by the holder elements into a recess, preferably a groove, of the base part.

## Revendications

1. Dispositif de raccordement électrique, en particulier pour un éclairage intérieur de véhicule, pour relier un composant électrique (17) remplaçable, de préférence un consommateur électrique, à un circuit imprimé (18), de préférence flexible, au moins une zone conductrice du circuit imprimé (18) étant en contact de serrage avec un support ou logement, présentant une partie de base (2) isolante de l'électricité et des éléments de maintien (4, 5) conducteurs de l'électricité, pour le composant (17), **caractérisé en ce que** les deux éléments de maintien (4, 5) sont reliés ensemble par l'intermédiaire d'un pont (6) séparable.

2. Dispositif de raccordement électrique selon la revendication 1, **caractérisé en ce que** la partie de base (2) présente au moins un creusement (3) pour le serrage du circuit imprimé (18) flexible, de préférence les éléments de maintien étant enfichés dans la partie de base (2), dans la zone du creusement (3).

3. Dispositif de raccordement électrique selon la revendication 1, **caractérisé en ce que** les éléments de maintien (4, 5) sont fabriqués en une tôle élastique conductrice de l'électricité.

4. Dispositif de raccordement électrique selon la revendication 1, **caractérisé en ce que** chaque élément de maintien (4, 5) présente un tronçon de liaison (7, 8) pour assurer une liaison à la partie de base (2), de préférence cunéiforme et avec un contour en dents de scie.

5. Dispositif de raccordement électrique selon la revendication 1, **caractérisé en ce que** le composant (17) est serré entre deux branches (11, 12) des éléments de maintien (4, 5).

6. Dispositif de raccordement électrique selon la revendication 1, **caractérisé en ce que** la partie de base (2) et les éléments de maintien (4, 5) forment une liaison indésolidarisable.

7. Dispositif de raccordement électrique selon la revendication 1, **caractérisé en ce qu'**une extrémité de chaque élément de maintien (4, 5) est munie d'un logement (15, 16) pour la partie de base (17).

8. Procédé de fabrication d'un dispositif de raccordement électrique selon au moins l'une des revendications précédentes, comprenant les étapes suivantes :
- enfoncement sous pression, dans une partie de base, de deux éléments de maintien d'abord reliés par un pont, entre la partie de base et les éléments de maintien étant disposé un circuit imprimé, de préférence flexible et, de ce fait, un contact de serrage étant établi entre les éléments de maintien et les zones conductrices du circuit imprimé flexible;
- coupure du pont entre les éléments de maintien, afin de créer deux éléments de maintien isolés électriquement l'un de l'autre.

9. Procédé selon la revendication 8, dans lequel l'enfoncement sous pression des éléments de maintien dans la partie de base et la coupure du pont entre les éléments de maintien se fait lors d'une étape opératoire, l'un après l'autre.

10. Procédé selon la revendication 8 ou 9, dans lequel le circuit imprimé est enfoncé par pression par les éléments de maintien dans un creusement, de référence une rainure, de la partie de base.
